# EUROPÄISCHE PATENTANMELDUNG

(11) **EP 0 804 053 A1**
(43) Veröffentlichungstag der Anmeldung: **29.10.1997**
(21) Anmeldenummer: 96118943.8
(22) Anmeldetag: 27.11.1996
(51) Int. Cl.: H05K 1/02, H05K 7/20

(54) **Baugruppenträger mit wenigstens einem wärmeerzeugenden Bauelement**

(30) Priorität: 23.04.1996 DE 19616083
(71) Anmelder: ROBERT BOSCH GMBH, 70442 Stuttgart (DE)
(72) Erfinder: Schilling, Wolfgang, 71701 Schwieberdingen (DE)

(57) **Zusammenfassung**

Bei einem insbesondere als Leiterplatte (1) ausgestalteten Baugruppenträger mit wärmeerzeugenden Bauelementen, Leiterbahnen und einer über den stromführenden Leiterbahnen aufgebrachten Wärmeleitpaste, kann die Wärmeableitung dadurch verbessert werden, daß die Wärmeleitpaste (7) direkt auf den stromführenden Leiterbahnen (5) aufgebracht ist. Zur Vermeidung eines Kurzschlusses zwischen den stromführenden Leiterbahnen (5) ist vorgesehen, die Wärmeleitpaste in Form von räumlich und elektrisch voneinander getrennten, den einzelnen stromführenden Leiterbahnen zugeordneten Strukturen (7) auf den stromführenden Leiterbahnen (5) im Siebdruckverfahren aufzudrucken. Die Wärmeableitung kann noch weiter verbessert werden, wenn zusätzlich zu den stromführenden Leiterbahnen nicht stromführende Leiterbahnen (6) auf dem Baugruppenträger unterhalb der Bauelemente (2) vorgesehen sind, die ebenfalls mit Wärmeleitpaste (7) großflächig bedruckt sind.

## Beschreibung

### Stand der Technik

Die Erfindung geht von einem Baugruppenträger, insbesondere einer Leiterplatte, mit wenigstens einem wärmeerzeugenden Bauelement nach der im Oberbegriff des Anspruchs 1 angegebenen Gattung aus.

Aus der EP 0 324 890 ist eine aus einem Isoliermaterial gefertigte Leiterplatte mit einem aufgedruckten Kohlewiderstand als wärmeerzeugendem Bauelement und einer gedruckten Schaltung bekannt. Das wärmeerzeugende Bauelement ist mit zwei Leiterbahnen der gedruckten Schaltung elektrisch leitend verbunden. Über der gedruckten Schaltung und dem Bauelement ist eine Deckschicht aus einer elektrisch gut isolierenden und daher auch thermisch isolierenden Paste großflächig aufgedruckt. Auf die isolierende Paste ist schließlich eine wärmeableitende Schicht aus einer Kupferpaste großflächig aufgedruckt, auf die wiederum eine weitere Deckschicht aus isolierender Paste aufgedruckt ist. Nachteilig bei diesem Stand der Technik ist, daß die durch das Bauelement auf die Leiterbahnen übertragene Wärme erst nach einem Wärmedurchgang durch die isolierende Paste an die wärmeableitende Schicht abgegeben werden kann. Da eine elektrisch isolierende Paste aber einen schlechten Wärmeleiter darstellt, ist der Wärmedurchgang durch die isolierende Paste oft nicht ausreichend, um eine effiziente Wärmeableitung zu ermöglichen. Deshalb kann bei elektronischen Bauelementen, welche im Betrieb eine sehr große Wärmeentwicklung aufweisen, die erzeugte Wärme nicht schnell genug abgeführt werden, so daß eine sich äußerst nachteilig auf die Funktionsweise der gedruckten Schaltung auswirkende Überhitzung des Bauelementes und der mit dem wärmeerzeugenden Bauelement verbundenen Leiterbahnen nicht ausgeschlossen werden kann.

### Vorteile der Erfindung

Der erfindungsgemäße Baugruppenträger mit den kennzeichnenden Merkmalen des Hauptanspruchs hat demgegenüber den Vorteil, daß die durch das wärmeerzeugende Bauelement auf die stromführenden, mit dem Bauelement verbundenen Leiterbahnen übertragene Wärme von den Leiterbahnen auf eine wärmeableitende Paste, welche direkt auf den Leiterbahnen aufgebracht ist, übertragen werden kann. Hierduch wird in vorteilhafter Weise eine Überhitzung der stromführenden Leiterbahnen und eine damit verbundene Störung der Funktionsweise der Schaltung vermieden. Die durch das Bauelement erzeugte Wärme kann so schneller vom Bauelement und den elektrischen Anschlüssen des Bauelementes abgeführt werden. Um einen ungewollten elektrischen Kontakt zwischen den stromführenden Leiterbahnen über die auch elektrisch leitende Wärmeleitpaste zu vermeiden, ist vorgesehen, die Wärmeleitpaste in räumlich und elektrisch getrennten, den einzelnen Leiterbahnen zugeordneten Strukturen auf die stromführenden Leiterbahnen aufzubringen. Die Herstellung des Baugruppenträgers ist kostengünstig, da bekannte Herstellungsverfahen benutzt werden können.

Die weiteren Unteranspüche beinhalten zusätzliche vorteilhafte Ausgestaltungen der Erfindung. Um eine thermische Entlastung der stromführenden Leiterbahnen zu erreichen, sind auf dem Baugruppenträger nach Unteranspruch 3 in unmittelbarer Umgebung des wärmeerzeugenden Bauelementes weitere nicht stromführende Leiterbahnen vorgesehen, auf welche die durch das Bauelement erzeugte Wärme direkt übertragen werden kann. Wenn die wärmeerzeugenden Bauelemente über den nicht stromführenden Leiterbahnen aufgebracht werden, kann die Wärme besonders gut auf die nicht stromführenden Leiterbahnen übertragen werden.

Nach Unteranspruch 5 ist vorgesehen, die wärmeableitende Paste auch auf die nicht stromführenden Leiterbahnen direkt aufzubringen. Hierdurch wird eine noch bessere Wärmeableitung erreicht.

Die großflächige Aufbringung der Wärmeleitpaste über den nicht stromführenden Leiterbahnen nach Anspruch 6 ermöglicht eine noch bessere Wärmeableitung.

Besonders vorteilhaft ist die Ausgestaltung der Erfindung nach Anspruch 7 und 8. Durch die Aufbringung einer zusätzlichen elektrisch isolierenden Lötstoppmaske auf die Wärmeleitpaste wird eine versehentliche Lötbrückenbildung und damit ein Kurzschluß zwischen Leiterbahnen und Lötstellen vermieden. Durch in der Lötstoppmaske vorgesehene Ausnehmungen kann die Wärme von den Bauelementen weiterhin an die Wärmeleitpaste abgeführt werden.

Weiterhin vorteilhaft ist die Ausgestaltung der Erfindung nach Anspruch 9. Durch die Aufbringung von Lotdepots auf die für die elektrische Verbindung der Bauelemente vorgesehenen Anschlußstellen der stromführenden Leiterbahnen können die Bauelemente mit ihren Anschlüssen derart auf die Lotdepots aufgebracht werden, daß sich die Bauelemente direkt über den wärmeableitenden Strukturen befindet. Vorteilhaft ist weiterhin, daß durch die als Anschlußstellen vorgesehenen Lotdepots an den jeweiligen Anschlüssen der Bauelemente keine konstruktiven Veränderungen vorgenommen werden müssen, um die Bauelemente über den wärmeableitenden Strukturen aufbringen zu können. Insbesondere vorteilhaft ist, daß auf dem erfindungsgemäßen Baugruppenträger Anschlußstellen für SMD-Bauelemente im Sipad- oder Optipad-Verfahren hergestellt werden können.

Besonders vorteilhaft ist weiterhin, die Wärmeleitpaste im Siebdruckverfahren auf die Leiterbahnen aufzubringen, da so bei der Herstellung der wärmeableitenden Strukturen gut bekannte und beherrschte Prozeßtechnologien benutzt werden können. Die mit Wärmeleitpaste bedruckten Flächen können im Siebdruckverfahren flexibel an das jeweilige Leiterbahnbild angepaßt werden.

### Zeichnung

Ein Ausführungsbeispiel der Erfindung ist in der Zeichnung dargestellt und wird in der nachfolgenden Beschreibung näher erläutert. Es zeigt
Fig. 1 einen Ausschnitt aus einem Querschnitt durch eine Leiterplatte mit stromführenden und nicht stromführenden Leiterbahnen, einer auf den Leiterbahnen aufgebrachten Wärmeleitpaste und einer Lötstoppmaske als Abdeckschicht,
Fig. 2 einen Ausschnitt aus einem Querschnitt durch dieselbe Leiterplatte und dieselben Leiterbahnen an einer anderen Stelle der Leiterplatte an der ein wärmeerzeugendes Bauelement auf die Leiterplatte aufgebracht ist.

### Beschreibung des Ausführungsbeispiels

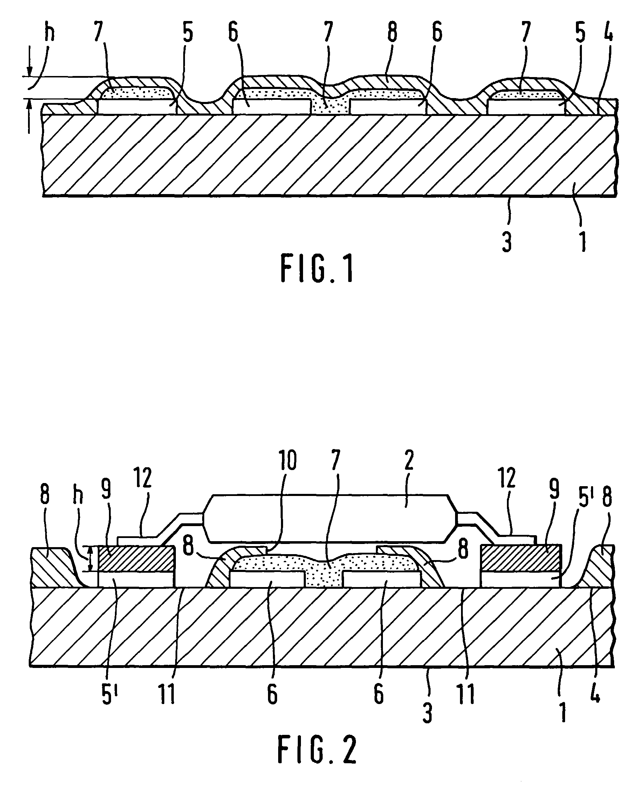

In Fig. 1 ist ein Ausschnitt aus einem Querschnitt durch einen als Leiterplatte ausgebildeten erfindungsgemäßen Baugruppenträger 1 gezeigt. Auf der Leiterplatte sind elektronische Bauelemente und Leiterbahnen auf der Oberseite 4 und der Unterseite 3 vorgesehen. Die Leiterbahnen auf der Oberseite 4 können über nicht gezeigte Durchkontaktierungen mit Leiterbahnen auf der Unterseite 3 der Leiterplatte verbunden sein. Die Leiterplatte kann aber auch als Mehrlagenleiterplatte mit auf mehreren Ebenen vorgesehenen Leiterbahnen ausgebildet sein. In Fig. 1 sind Leiterbahnen und Bauelemente der Einfachheit halber nur auf der Oberseite 4 der Leiterplatte 1 dargestellt. Es sind stromführende, der elektronischen Schaltung zugeordnete und mit den einzelnen Bauelementen elektrisch verbundene Leiterbahnen 5 und nicht stromführende Leiterbahnen 6 vorgesehen, von denen in Fig. 1 jeweils zwei Leiterbahnen im Querschnitt dargestellt sind. Wie sich in Fig. 1 weiterhin erkennen läßt, weisen die Leiterbahnen einen im wesentlichen rechteckigen Querschnitt auf. Die Leiterbahnen können beispielsweise aus Kupfer bestehen und werden in an sich bekannter Weise auf die Leiterplatte aufgebracht. Die nicht stromführenden Leiterbahnen können mit einer in Fig. 1 nicht gezeigten gemeinsamen Masseebene der Leiterplatte über Durchkontaktierungen verbunden sein.

Auf die stromführenden Leiterbahnen 5 und die nicht stromführenden Leiterbahnen 6 ist eine Wärmeleitpaste 7 aufgebracht. Als Material für die Wärmeleitpaste können verschiedene, gut wärmeleitende Pasten verwandt werden. Die Wärmeleitpaste in dem hier gezeigten Ausführungsbeispiel besteht aus einer Kupfer-Dickschichtpaste. Besonders einfach ist es, die Wärmeleitpaste 7 im Siebdruckverfahren einfach auf die Leiterbahnen 5 und 6 in an sich bekannter Weise aufzudrucken. Dabei kann die Wärmeleitpaste 7 in einem Druckschritt auf die Leiterbahnen 5 und 6 aufgedruckt werden.

Wie in Fig. 1 gezeigt ist, wird die Wärmeleitpaste 7 dabei in Form von räumlich und elektrisch getrennten, den einzelnen stromführenden Leiterbahnen 5 zugeordneten Strukturen auf die Leiterbahnen 5 aufgedruckt, so daß eine unbeabsichtigte elektrische Verbindung zwischen zwei stromführenden Leiterbahnen 5 durch die auch elektrisch leitende Wärmeleitpaste ausgeschlossen ist. Im Siebdruckverfahren kann die Wärmeleitpaste so auf die Leiterbahnen aufgedruckt werden, daß nur auf die der Leiterplatte 1 abgewandte Oberseite der Leiterbahnen 5 Wärmeleitpaste aufgetragen wird. Dadurch wird erreicht, daß Wärmeleitpaste 7 mit einer auf das Leiterbahnbild der stromführenden Leiterbahnen 5 beschränkten Flächenstruktur auf die stromführenden Leiterbahnen 5 aufgedruckt wird. Die Wärmeleitpaste wird, wie in Fig. 2 dargestellt, mit Ausnahme der für den Anschluß der elektronischen Bauelemente 2 vorgesehenen Anschlußstellen 5' auf die stromführenden Leiterbahnen 5 aufgedruckt. Da in den Zwischenräumen zwischen jeweils zwei stromführenden Leiterbahnen 5 und in den Zwischenräumen zwischen den stromführenden Leiterbahnen 5 und den nicht stromführenden Leiterbahnen 6 keine Wärmeleitpaste vorgesehen ist, ist eine Kurzschlußbildung zwischen den stromführenden Leiterbahnen 5 nicht möglich. Die so strukturierte Auftragung der Wärmeleitpaste 7 auf die stromführenden Leiterbahnen 5 ist mit dem Siebdruckverfahren leicht durchzuführen und verursacht keine zusätzlichen Kosten gegenüber einer großflächigen Auftragung der Wärmeleitpaste.

Bei den nicht stromführenden Leiterbahnen 6 ist zur weiteren Verbesserung der Wärmeableitung vorgesehen, die Wärmeleitpaste 7 großflächig aufzudrucken, wobei auch die Zwischenräume zwischen den nicht stromführenden Leiterbahnen 6 mit Wärmeleitpaste 7 bedruckt werden. Dies ist in Fig. 1 am Beispiel zweier benachbarter nicht stromführender Leiterbahnen 6 gezeigt. Weiterhin können, abweichend von dem hier gezeigten Ausführungsbeispiel, die auf verschiedenen Ebenen einer Mehrlagenleiterplatte vorgesehenen nichtstromführenden Leiterbahnen 6 über die Wärmeleitpaste 7 wärmeleitend verbunden werden. Zu diesem Zweck können mit Wärmeleitpaste gefüllte Bohrungen in der Leiterplatte vorgesehen sein. Bei dem in der Fig. 1 gezeigten Ausführungsbeispiel kann so die Wärme zum Beispiel von der Oberseite 4 auf die Unterseite 3 der Leiterplatte abgeleitet werden.

Da es durch das fehlerhafte Funktionieren einer Lötmaschine bei der Bestückung der Leiterplatte oder einen schlechten Entwurf des Leiterbahnbildes zu Lötbrücken, also Kurzschlüssen zwischen den stromführenden Leiterbahnen 5 und benachbarten Anschlußstellen 5' anderer stromführender Leiterbahnen oder zu einer unerwünschten elektrischen Verbindung zwischen zwei benachbarten Leiterbahnen kommen kann, wird auf die Leiterplatte 1 eine an sich bekannte Lötstoppmaske 8 im Siebdruckverfahren aufgedruckt. Die aus einem elektrisch isolierenden Material bestehende Lötstoppmaske 8 wird als hitzebeständiger Abdecklack, wie in Fig. 1 gezeigt, auf die Leiterbahnen 5,6 und die zwischen den Leiterbahnen befindliche Leiterplattenoberfläche 4 in bekannter Weise aufgedruckt. Wie in Fig. 2 gezeigt, werden die zur Verlötung der Anschlüsse 12 eines Bauelementes 2 vorgesehenen Anschlußstellen 5' der Leiterbahnen 5 nicht mit der Lötstoppmaske bedruckt. Die in der Lötstoppmaske an den Anschlußstellen 5' vorgesehenen Ausnehmungen 11 sollten möglichst etwas größer als die Anschlußstellen 5' sein, damit diese nicht von der Lötstoppmaske 8 bedeckt werden. Wie in Fig. 2 gezeigt, sind die Anschlußstellen 5' innerhalb der Ausnehmungen 11 der Lötstoppmaske 8 auf der Oberseite 4 der Leiterplatte 1 angeordnet. Die Anschlußstellen 5' können beispielsweise in Form von Lötaugen ausgebildet sein. Auf die Anschlußstellen 5' der Leiterbahnen 5 sind Lotdepots 9 aufgebracht. Die Lotdepots 9 weisen eine definierte Höhe h auf und können im bekannten Sipad- oder Optipad-Verfahren auf den Anschlußstellen 5' hergestellt werden. Bei diesen Verfahren wird das Lot an den dafür vorgesehenen Stellen aufgewalzt. Die Höhe h der Lotdepots 9 entspricht der Höhe der auf den nicht stromführenden Leiterbahnen 6 insgesamt aufgebrachten Strukturen aus Wärmeleitpaste 7 und Lötmaske 8. Weiterhin ist ein SMD-Bauelement 2, welches im Betriebszustand eine starke Wärmeentwicklung aufweist, mit seinen Anschlüssen 12 auf den Lotdepots 9 aufgelötet. Da die Höhe h der Lotdepots 9 der Höhe der auf den Leiterbahnen 6 bzw. 5 aufgebrachten Strukturen entspricht, befindet sich das Bauelement 2 direkt über diesen Strukturen. In Fig. 2 befindet sich die Unterseite des SMD-Bauelementes 2 direkt über den nicht stromführenden Leiterbahnen 6, der darauf aufgebrachten Wärmeleitpaste 7 und der Lötstoppmaske 8. Die nicht gut wärmeableitende Lötstoppmaske 8 weist deshalb an der Stelle des aufgebrachten Bauelementes 2 eine Ausnehmung 10 auf. Die durch das Bauelement 2 erzeugte Wärme kann so unmittelbar durch die Ausnehmung 10 der Lötstoppmaske 8 auf die wärmeableitende Schicht 7 übertragen werden und von der Schicht 7 und den Leiterbahnen 6 abgeleitet werden. Hierfür ist es zweckmäßig, eine der Größe des Bauelementes 2 entsprechende Größe der Ausnehmung 10 vorzusehen, damit ein Großteil der von der Unterseite des Bauelementes 2 abgegebenen Wärme auf die Wärmeleitpaste 7 übertragen werden kann. Ein Teil der durch das Bauelement erzeugten Wärme wird von den Anschlüsse 12 auf die Lotdepots 9 und die Anschlußstellen 5' der Leiterbahnen 5 übertragen. Diese Wärme kann, wie in Fig. 1 gezeigt, durch die stromführenden Leiterbahnen 5 mit der darauf aufgebrachten Wärmeleitpaste 7 schnell abgeführt werden. Durch den erfindungsgemäßen Baugruppenträger wird somit eine schnelle und effiziente Wärmeableitung der von den Bauelementen erzeugten Wärme ermöglicht.

## Patentansprüche

1. Baugruppenträger (1), insbesondere Leiterplatte, mit wenigstens einem wärmeerzeugenden Bauelement (2), mit auf den Baugruppenträger (1) aufgebrachten stromführenden Leiterbahnen (5) und mit einer über den stromführenden Leiterbahnen (5) aufgebrachten Wärmeleitpaste (7), **dadurch gekennzeichnet,** daß die Wärmeleitpaste (7) direkt auf den stromführenden Leiterbahnen (5) aufgebracht ist, wobei Mittel zur Vermeidung eines Kurzschlusses zwischen den stromführenden Leiterbahnen (5) vorgesehen sind.

2. Baugruppenträger nach Anspruch 1, **dadurch gekennzeichnet**, daß als Mittel zur Vermeidung eines Kurzschlusses zwischen den stromführenden Leiterbahnen (5), die Wärmeleitpaste (7) in Form von räumlich und elektrisch voneinander getrennten, den einzelnen Leiterbahnen (5) zugeordneten Strukturen auf den stromführenden Leiterbahnen (5) aufgebracht ist.

3. Baugruppenträger nach Anspruch 1 oder 2, **dadurch gekennzeichnet**, daß zusätzlich nicht stromführende Leiterbahnen (6) auf dem Baugruppenträger (1) vorgesehen sind und das wenigstens eine wärmeerzeugende Bauelement (2) in direkter Nähe zu den nicht stromführenden Leiterbahnen (6) auf den Baugruppenträger (1) aufgebracht ist.

4. Baugruppenträger nach Anspruch 3, **dadurch gekennzeichnet,** daß das wenigstens eine wärmeerzeugende Bauelement (2) über den nicht stromführenden Leiterbahnen (6) vorgesehen ist.

5. Baugruppenträger nach Anspruch 3 oder 4, **dadurch gekennzeichnet,** daß auf die nicht stromführenden Leiterbahnen (6) Wärmeleitpaste (7) direkt aufgebracht ist.

6. Baugruppenträger nach Anspruch 5, **dadurch gekennzeichnet,** daß die Wärmeleitpaste (7) großflächig auf die nicht stromführenden Leiterbahnen (6) aufgebracht ist.

7. Baugruppenträger nach einem der vorstehenden Ansprüche, **dadurch gekennzeichnet,** daß über der Wärmeleitpaste (7) eine Lötstoppmaske (8) als abdeckende Schicht auf dem Baugruppenträger (1) vorgesehen ist, welche am Ort der Anschlußstellen (5') der stromführenden Leiterbahnen (5) Ausnehmungen (11) aufweist.

8. Baugruppenträger nach Anspruch 7, **dadurch gekennzeichnet,** daß die über der Wärmeleitpaste (7) aufgebrachte Lötstoppmaske (8) am Ort des wenigstens einen Bauelementes (2) eine Ausnehmung (10) aufweist.

9. Baugruppenträger nach einem der vorstehenden Ansprüche, **dadurch gekennzeichnet,** daß auf den für die elektrische Verbindung mit den Anschlüssen (12) der Bauelemente (2) vorgesehenen Anschlußstellen (5') der stromführenden Leiterbahnen (5) Lotdepots (9) aufgebracht sind, deren Höhe (h) der Höhe der insgesamt auf den stromführenden Leiterbahnen (5) und den nicht stromführenden Leiterbahnen (6) aufgebrachten Strukturen entspricht.

10. Baugruppenträger nach einem der vorstehenden Ansprüche, **dadurch gekennzeichnet,** daß die Wärmeleitpaste (7) im Siebdruckverfahren auf den Baugruppenträger (1) aufgedruckt wird.
